# EUROPEAN PATENT APPLICATION

(11) **EP 1 593 984 A1**
(43) Date of publication of application: **09.11.2005**
(21) Application number: 04101830.0
(22) Date of filing: 29.04.2004
(51) Int. Cl.: G01R 33/567, G01R 33/563

(54) **Inversion recovery magnetic resonance angiography**

(71) Applicant: Koninklijke Philips Electronics N.V., 5621 BA Eindhoven (NL); Philips Intellectual Property & Standards GmbH, 20099 Hamburg (DE)
(72) Inventor: The designation of the inventor has not yet been filed
(74) Representative: Cohen, Julius Simon

(57) **Abstract**

The invention relates to a device for magnetic resonance imaging of a body placed in a stationary and substantially homogeneous main magnetic field. In order to provide an MR device which is arranged to generate angiographic images without motion artifacts and with a high CNR in acceptable scan times, the invention proposes that the device is arranged to register a hearbeat signal (R) in monitored heartbeat data, subject at least a portion of the body to a spatially selective inversion recovery RF pulse (IR), wherein the peak signal (R) and the inversion recovery RF pulse (IR) are separated by a trigger delay period (TD), generate a series of MR imaging signals by further subjecting the portion of the body to an imaging sequence (TFE) after an inversion delay period (ID), and to measure said MR imaging signals for reconstructing an MR image therefrom.

## Description

The invention relates to a device for magnetic resonance imaging of a body placed in a stationary and substantially homogeneous main magnetic field.

Furthermore, the invention relates to a method for magnetic resonance imaging and to a computer program for a magnetic resonance imaging device.

In magnetic resonance imaging (MRI), pulse sequences consisting of RF and magnetic field gradient pulses are applied to an object (a patient) to generate magnetic resonance signals, which are scanned in order to obtain information therefrom and to reconstruct images of the object. Since its initial development, the number of clinical relevant fields of application of MRI has grown enormously. MRI can be applied to almost every part of the body, and it can be used to obtain information about a number of important functions of the human body. The pulse sequence which is applied during a MRI scan determines completely the characteristics of the reconstructed images, such as location and orientation in the object, dimensions, resolution, signal-to-noise ratio, contrast, sensitivity for movements, etcetera. An operator of a MRI device has to choose the appropriate sequence and has to adjust and optimize its parameters for the respective application.

Known methods of the type specified above can be employed for magnetic resonance angiography (MRA).

In the past, methods for magnetic resonance imaging of the renal arteries have been of limited clinical value for several reasons. It is known that MRA is generally difficult since the breathing of the examined patient causes a periodic motion of the internal structures of the body of the patient. The imaging situation is further complicated by the beating motion of the heart of the patient which is added to the breathing motion. Both motions, heart motion and breathing motion, are present during the relatively long period of acquisition of MR signals and cause undesirable artifacts in the resulting images. Image quality may be degraded because of motion blurring for example. Renal MRA is particularly susceptible to the mentioned motion artifacts which have an extremely disturbing effect on the diagnostic outcome of the imaging procedure.

It is known that the beating motion of the heart is fastest during systole and relatively motionless during diastole, in which the heart is fully expanded. Thus, MR images reconstruced from MR signals acquired during a diastole provide the clearest images of the organ of interest. The breathing motion in turn can be eliminated by simply asking the examined patient to hold his or her breath during the acquisition of MR signals or by acquiring the MR signals during quiet breathing periods.

According to known methods for renal MR imaging, the ECG of the examined patient is monitored in order to synchronize the acquisition of MR signals with the heart cycle. The ECG signal is a repetitive pattern reflecting the electrical activity of the patients heart. Each cardiac cycle begins with a so-called R-wave (highest amplitude peak) in the ECG signal during the systole period and ends with the diastole period almost without any electrical activity. The acquisition of MR signals can be activated (triggered) correspondingly such that image data may be obtained during the relatively motionless diastole period.

Particularly in renal MR, contrast-enhanced imaging (CE-MRA) is often the method of choice in order to obtain a sufficient contrast between the blood vessels of interest and the surrounding tissue. Since it is necessary to perform imaging during a breathhold to avoid breathing motion, the problem arises that the time available for MR signal acquisition is very limited. Moreover, during the breathhold, a drift of the diaphragm often occurs, leading to motion of the renal arteries. Consequently, a major drawback of known MRA techniques is that they fail to produce high quality images with a sufficient resolution and without motion artifacts.

Therefore it is readily appreciated that there is a need for an improved device for magnetic resonance imaging which enables the acquisition and reconstruction of high quality MR images of the renal arteries. It is consequently the primary object of the present invention to provide an MR device which is arranged to generate images without motion artifacts and with a high CNR in acceptable scan times.

In accordance with the present invention, a device for magnetic resonance imaging of a body placed in a stationary and substantially homogeneous main magnetic field is disclosed, the device comprising means for establishing the main magnetic field, means for generating magnetic field gradients superimposed upon the main magnetic field, means for radiating RF pulses towards the body, control means for controlling the generation of the magnetic field gradients and the RF pulses, means for receiving and sampling magnetic resonance signals generated by sequences of RF pulses and switched magnetic field gradients, reconstruction means for forming an image from the signal samples, and heartbeat detection means for monitoring heartbeat data from the body. The device of the present invention is arranged to
a) register a peak signal in the heartbeat data,
b) subject at least a portion of the body to a spatially selective inversion recovery RF pulse, the peak signal and the inversion recovery RF pulse being separated by a trigger delay period,
c) generate a series of MR imaging signals by subjecting the portion to an imaging sequence after an inversion delay period,
d) measure the MR imaging signals for reconstructing an MR image from the signals.

The heartbeat detection means of the device according to the present invention can be, for example, a finger pulse detector or a conventional digital ECG monitoring device.

The invention advantageously enables the fast and reliable generation of high quality in particular renal MR angiographic images without the administration of a contrast agent to the examined patient. This is achieved by the continuous monitoring of the heartbeat during image acquisition in combination with the generation of the spatially selective inversion recovery RF pulse. While the method of the invention is particularly valuable for renal MRA, it can also be applied to other magnetic resonance imaging techniques.

For example, in correspondence with the detection of R-waves in the ECG signal, MR signals for image reconstruction are preferably acquired during the quiet diastole phase of the heart cycle, after inflow of fresh non-inverted blood into the region affected by the inversion recovery RF pulse has taken place. It is made sure in this way that no MR signals are processed during image reconstruction by which blurring or other motion artifacts due to the beating of the heart would be introduced into the final image, and that a good contrast to noise ratio is obtained.

MR signals originating from tissue surrounding the vessels of interest can be almost completely supressed by means of the inversion recovery RF pulse. In contrary, the MR signals of the blood flowing into the region affected by the spatially selective inversion recovery RF pulse in the time between the generation of the inversion recovery RF pulse and the imaging sequence will have a high amplitude. This is simply because the blood spins are not inverted outside the region affected by the inversion recovery pulse. In this way, a high contrast to noise ratio can be achieved with the method of the invention.

Subsequent to the irradiation of the spatially selective inversion recovery RF pulse, usually a series of phase-encoded spin echoes is generated by an appropriate imaging sequence of RF pulses and magnetic field gradient pulses in accordance with the present invention. These spin echoes are measured as MR imaging signals for reconstructing an MR image therefrom, for example by 2D Fourier transformation.

The suppression of the MR signals originating from tissue surrounding the vessels to be imaged can be optimized by appropriate selection of the inversion delay period before the generation of the imaging sequence. In order to optimize the contrast of the reconstructed image, the trigger delay period between the R-wave and the inversion recovery pulse should be selected such that the blood within the region affected by the inversion recovery pulse has been exchanged at the time the MR imaging signal acquisition starts. This is typically after systole. It is known that the heart is in the relatively motionless diastolic phase after a certain period of time after the occurrence of an R-wave. Consequently, the value of the trigger delay period can be determined according to a general rule which establishes a dependency on the average heart rate.

In accordance with the present invention it is advantageously possible to acquire the MR signals over a plurality of cardiac cycles or at least over more than one cardiac cycle. With the known imaging sequences of RF pulses and magnetic field gradient pulses it is often not possible to acquire a complete set of MR signals as required for the reconstruction of the desired MR image within a single cardiac cycle. Hence, the proposed device can easily be applied such that MR signals with different phase encoding values used for reconstruction of a single image are acquired during the diastoles of two or more successive heart cycles.

Because respiratory motion can severely deteriorate the image quality of MR angiography, gating and image correction based on respiratory signals, such as MR navigator signals or respiratory belt signals, can be introduced to reduce these artifacts. By means of such MR navigator signals, the position of the diaphragm can be monitored and used as an input for an appropriate gating algorithm. Furthermore, the information of the navigator signal may be used to perform motion correction to improve image quality.

For registering the MR navigator signals, special pulse sequences known as such in the art may be used with the device of the invention. These excite a spatially restricted volume, for example of pencil beam shape, which is read out using a gradient echo. This allows to monitor motions of the examined portion of the body along one direction. In MRA, the navigator volume is usually localized at the dome of the right hemidiaphragm such that the motion of the diaphragm can be observed by the image contrast between the liver and the lung.

In practice, the MR navigator signal of the present invention can advantageously be employed for gating of the imaging sequence and/or for adjusting the parameters of the imaging sequence and/or for correction of the MR image. Regarding the image quality, good results are obtained if both gating and adaptive motion correction of the imaged volume (so-called slice-tracking) are performed.

The proposed MRA technique offers different opportunities to select optimal values for both the trigger delay period and the inversion delay period. In order to obtain an optimal contrast to noise ratio in the reconstructed angiographic images it is useful to prescribe the inversion delay period such that MR signals originating from tissue within the region affected by the inversion recovery RF pulse are substantially zero. In this way, the spatially selective inversion recovery RF pulse is effectively used for signal-nulling of the tissue surrounding the vessels of interest. Furthermore, the trigger delay period should be prescribed such that MR signals originating from blood flowing into the region affected by the inversion recovery RF pulse are maximized. The blood spins outside of this region are not affected by the inversion recovery pulse. Consequently, the vessels filled with blood, which is completely exchanged during the time interval between the inversion recovery RF pulse and the beginning of the acquisition of the imaging signals, are clearly depicted in the reconstructed images with a good contrast. It is advantageous to choose the trigger delay such that the inversion recovery RF pulse is generated immediately before the systolic phase during which the inflow of blood into the examined region is maximum.

In terms of imaging speed, it is particularly useful if the imaging sequence of the method of the invention is a turbo field echo (TFE) sequence. It turns out in practice that good results are obtained with a TFE sequence with cartesian k-space acquisition. Radial and spiral acquisition schemes are also possible with slightly reduced signal to noise and contrast to noise ratio. The imaging technique of the invention works best if the amplitudes of the individual acquired MR signals are approximately constant. Hence, the method of the invention may advantageously be applied in combination with a so-called steady state free precession (SSFP) acquisition scheme as it is known in the art as such. Preferably, the imaging sequence for MR signal acquisition may be a balanced turbo field echo (B-TFE) sequence.

The invention not only relates to a device but also to a method for magnetic resonance imaging of at least a portion of a body placed in a stationary and substantially homogeneous main magnetic field, the method comprising the following steps:
a) registering a hearbeat signal in heartbeat data recorded from said body,
b) subjecting at least a portion of said body to a spatially selective inversion recovery RF pulse, said heartbeat signal and said inversion recovery RF pulse being separated by a trigger delay period,
c) generating a series of MR imaging signals by subjecting said portion to an imaging sequence after an inversion delay period,
d) measuring said MR imaging signals for reconstructing an MR image from said signals.

A computer program adapted for carrying out the imaging procedure of the invention can advantageously be implemented on any common computer hardware, which is presently in clinical use for the control of magnetic resonance scanners. The computer program can be provided on suitable data carriers, such as CD-ROM or diskette. Alternatively, it can also be downloaded by a user from an internet server.

The following drawings disclose preferred embodiments of the present invention. It should be understood, however, that the drawings are designed for the purpose of illustration only and not as a definition of the limits of the invention.

In the drawings:
Fig.1 shows an embodiment of a magnetic scanner according to the invention,
Fig.2 shows a diagram of the imaging procedure in accordance with the present invention.

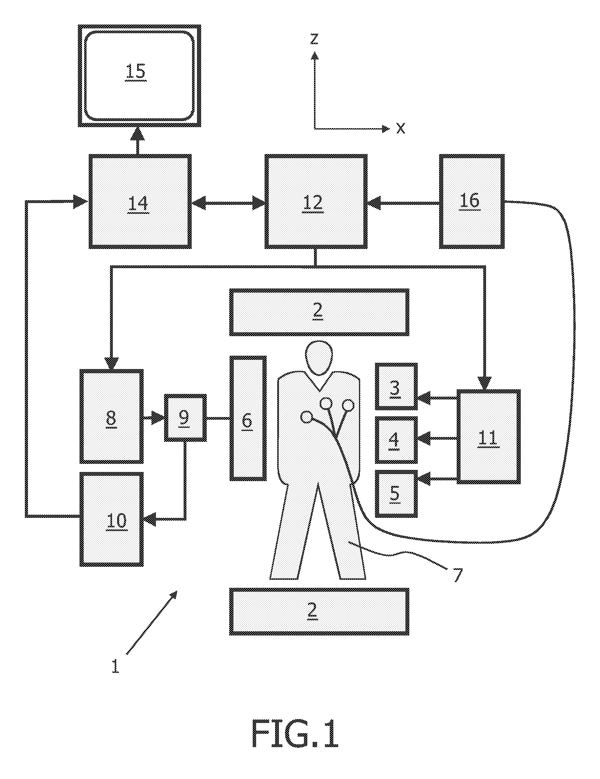

In Fig.1 a magnetic resonance imaging device 1 in accordance with the present invention is diagrammatically shown. The apparatus 1 comprises a set of main magnetic coils 2 for generating a stationary and homogeneous main magnetic field and three sets of gradient coils 3, 4 and 5 for superimposing additional magnetic fields with controllable strength and having a gradient in a selected direction. Conventionally, the direction of the main magnetic field is labelled the z-direction, the two directions perpendicular thereto the x- and y-directions. The gradient coils are energized via a power supply 11. The apparatus 1 further comprises a radiation emitter 6, an antenna or coil, for emitting radio frequency (RF) pulses to a body 7, the radiation emitter 6 being coupled to a modulator 8 for generating and modulating the RF pulses. Also provided is a receiver for receiving the MR signals, the receiver can be identical to the emitter 6 or be separate. If the emitter and receiver are physically the same antenna or coil as shown in Fig.1, a send-receive switch 9 is arranged to separate the received signals from the pulses to be emitted. The received MR signals are input to a demodulator 10. The modulator 8, the emitter 6 and the power supply 11 for the gradient coils 3, 4 and 5 are controlled by a control system 12 to generate the above-described spatially selective inversion recovery RF pulse and the actual imaging sequence. The control system is usually a microcomputer with a memory and a program control. For the practical implementation of the invention it comprises a programming with a description of an imaging procedure as described above. The demodulator 10 is coupled to a data processing unit 14, for example a computer, for transformation of the received echo signals into an image that can be made visible, for example, on a visual display unit 15. As a hearbeat detection means there is an ECG means 16 for registering the ECG of the patient 7 during acquisition of MR signals, which may be for example a standard digital ECG recording device, connected to the control system 12. The ECG means 16 in turn is connected to the patient 7 via a cable and appropriate electrodes. Alternatively, the heartbeat of the patient 7 could also be monitored by means of a simple finger pulse detector.

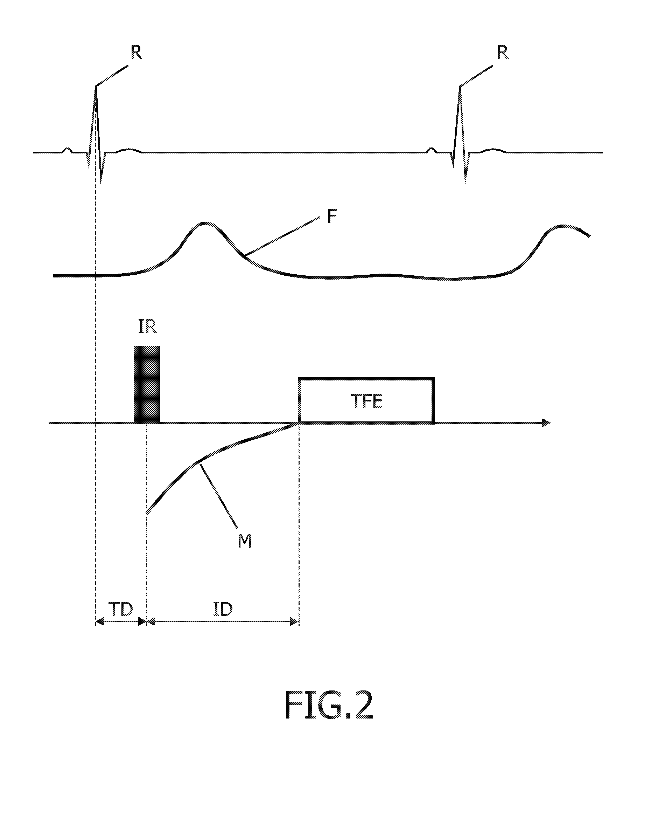

Fig.2 illustrates the actual imaging procedure carried out on the magnetic resonance device of the invention. The figure shows an ECG signal of a patient with two R-waves designated by R. The individual heart cycles are determined by the time intervals between the successive R-waves. In accordance with the invention, the depicted ECG signal is monitored continuously during the acquisition of MR signals, and the R-waves R are detected automatically, for example by means of a computer and an appropriate program which evaluates the digitized ECG signal. The curve designated by F represents the blood flow within a vessel to be imaged. A spatially selective inversion recovery RF pulse IR is irradiated after a trigger delay period TD from the detection of the first R-wave. A series of magnetic resonance imaging signals is generated by means of an imaging sequence TFE beginning after an inversion delay period ID. During the period ID, nuclear magnetization M of tissue within the region affected by the spatially selective pulse IR undergoes longitudinal relaxation. The imaging sequence starts when the magnetization M is substantially zero, such that the tissue surrounding the vessels of interest within the imaging volume is effectively suppressed in the reconstructed image. As can further be seen in Fig.2, the maximum inflow F of blood into the region to be imaged occurs after the irradiation of the pulse IR. It can thus be achieved by appropriate prescription of the intervals TD and ID that after the spatially selective inversion recovery most of the blood within the imaging volume has been exchanged before the actual MR signal acquisition TFE begins. In this way, a high contrast to noise ratio between the blood-filled vessels and the surrounding tissue is obtained. The pulsatile motion of the heart has no adverse effect on image quality since the MR signal acquisition is inherently synchronized with the ECG. Optionally, breathing motion can be compensated for either by breathholding or by respiratory gating, for example by means of an appropriate navigator signal acquisition, which is not shown in the figure.

## Claims

1. Device for magnetic resonance imaging of a body (7) placed in a stationary and substantially homogeneous main magnetic field. the device comprising means (2) for establishing said main magnetic field, means (3, 4, 5) for generating magnetic field gradients superimposed upon said main magnetic field, means (6) for radiating RF pulses towards said body (7), control means (12) for controlling the generation of said magnetic field gradients and said RF pulses, means (10) for receiving and sampling magnetic resonance signals generated by sequences of RF pulses and switched magnetic field gradients, reconstruction means (14) for forming an image from said signal samples, and heartbeat detection means (16) for monitoring heartbeat data of said body (7), wherein the device is arranged to
a) register a heartbeat signal (R) in said heartbeat data,
b) subject at least a portion of said body (7) to a spatially selective inversion recovery RF pulse (IR), said heartbeat signal (R) and said inversion recovery RF pulse (IR) being separated by a trigger delay period (TD),
c) generate a series of MR imaging signals by subjecting said portion to an imaging sequence (TFE) after an inversion delay period (ID),
d) measure said MR imaging signals for reconstructing an MR image from said signals.

2. Device of claim 1, wherein the device is further arranged to subject said body (7) to a navigator sequence prior to subjecting said portion to said imaging sequence.

3. Device of claim 2, wherein the device is further arranged to measure a navigator signal and to employ said navigator signal for gating of said imaging sequence and/or for adjusting the parameters of said imaging sequence and/or for correction of said MR image.

4. Device of claim 1, wherein the device is further arranged to register respiratory motion of said body (7) by means of an external sensor and to employ the signal of said external sensor for gating of said imaging sequence.

5. Device of claim 1, wherein said inversion delay period is prescribed such that said MR imaging signals originating from tissue within the region affected by said inversion recovery RF pulse are substantially zero.

6. Device of claim 1, wherein said trigger delay period is prescribed such that said MR imaging signals originating from blood flowing into the region affected by said inversion recovery RF pulse are maximized.

7. Device of claim 1, wherein said imaging sequence (TFE) is a turbo field echo sequence.

8. Method for magnetic resonance imaging (MRI) of at least a portion of a body placed in a stationary and substantially homogeneous main magnetic field, the method comprising the following steps:
a) registering a heartbeat signal (R) in heartbeat data recorded from said body,
b) subjecting at least a portion of said body to a spatially selective inversion recovery RF pulse (IR), said heartbeat signal (R) and said inversion recovery RF pulse (IR) being separated by a trigger delay period (TD),
c) generating a series of MR imaging signals by subjecting said portion to an imaging sequence (TFE) after an inversion delay period (ID),
d) measuring said MR imaging signals for reconstructing an MR image from said signals.

9. Method of claim 8, wherein said inversion delay period (ID) is prescribed such that said MR imaging signals originating from tissue within the region affected by said inversion recovery RF pulse are substantially zero, and wherein said trigger delay (TD) period is prescribed such that said MR imaging signals originating from blood flowing into said region are maximized.

10. A computer program for a magnetic resonance imaging device, with instructions for
a) registering a heartbeat signal (R) in heartbeat data,
b) controlling the generation of a spatially selective inversion recovery RF pulse (IR) such that the heartbeat signal (R) and said inversion recovery RF pulse (IR) are separated by a trigger delay period (TD),
c) controlling the generation and the measurement of a series of MR imaging signals after an inversion delay period,
d) reconstructing an MR image from said MR imaging signals.
